# EUROPÄISCHE PATENTSCHRIFT

(11) **EP 2 964 417 B1**
(45) Veröffentlichungstag und Bekanntmachung des Hinweises auf die Patenterteilung: **12.01.2022**
(21) Anmeldenummer: 14726069.9
(22) Anmeldetag: 03.04.2014
(51) Int. Cl.: B23K 26/0622, B23K 26/53, B23K 101/40, B23K 103/00

(54) **VERFAHREN ZUM EINBRINGEN VON DURCHBRECHUNGEN IN EIN SUBSTRAT**
METHOD FOR PROVIDING THROUGH-OPENINGS IN A SUBSTRATE
PROCÉDÉ PERMETTANT DE PRATIQUER DES PERFORATIONS DANS UN SUBSTRAT

(30) Priorität: 04.04.2013 DE 102013103370; 31.10.2013 DE 102013112033
(43) Veröffentlichungstag der Anmeldung: 13.01.2016
(73) Patentinhaber: LPKF Laser & Electronics AG, 30827 Garbsen (DE)
(72) Erfinder: KRÜGER, Robin, Alexander, 30173 Hannover (DE); AMBROSIUS, Norbert, 47624 Kevelaer (DE); OSTHOLT, Roman, 30855 Langenhagen (DE)
(74) Vertreter: Scheffler, Jörg
(86) Internationale Anmeldenummer: PCT/DE2014/100118
(87) Internationale Veröffentlichungsnummer: WO 2014/161534

(56) Entgegenhaltungen:
- WO-A1-2012/094737
- WO-A2-2012/006736
- DE-A1- 10 154 361
- JP-A- S59 127 983
- JP-A- 2005 288 503
- US-A- 4 911 783
- US-A1- 2007 298 529
- US-A1- 2012 142 186

## Beschreibung

Die Erfindung betrifft ein Verfahren gemäß dem Oberbegriff des Anspruchs 1 (siehe zum Beispiel JP2005288503) zum Einbringen einer Mehrzahl von Durchbrechungen in ein als Interposer oder Mikrobauteil einsetzbares Substrat mittels eines Laserstrahles.

Derartige Substrate werden als sogenannte Interposer zur elektrischen Verbindung der Anschlüsse mehrerer homogener oder heterogener Mikrochips eingesetzt. Der Interposer besteht im Allgemeinen aus Glas oder Silizium und enthält beispielsweise Kontaktflächen, Umverdrahtungen, Durchkontaktierungen sowie aktive und nicht aktive Komponenten.

Ein Mikrochip als Prozessorkern hat typischerweise auf seiner Unterseite auf relativ kleiner Fläche verteilt mehrere Hundert Kontaktpunkte in engem Abstand zueinander. Wegen dieses engen Abstandes können diese Kontaktpunkte nicht direkt auf eine Schaltungsplatte, das sogenannte Motherboard, aufgebracht werden. Es wird deshalb ein Interposer als Verbindungselement eingesetzt, mit welchem die Kontaktierungsbasis verbreitert werden kann.

Als Interposer wird in der Praxis beispielsweise eine mit Glasfaser verstärkte Epoxydharzplatte eingesetzt, die mit einer Anzahl von Löchern versehen ist. Auf der Oberfläche der Glasfasermatte laufen Leiterbahnen, die in die jeweiligen Löcher hineinführen, um diese zu verfüllen, und auf der anderen Seite der Glasfasermatte bis zu den Anschlusskontakten des Prozessorkernes führen. Bei Auftreten von Erwärmung kommt es allerdings zu unterschiedlichen Ausdehnungen zwischen dem Kernprozessor und der Glasfasermatte und damit zu mechanischen Spannungen zwischen diesen beiden Komponenten.

Um die infolge der unterschiedlichen Temperaturausdehnungskoeffizienten auftretenden Spannungen zu reduzieren, werden daher auch Silizium-Interposer eingesetzt. Die Silizium-Interposer können in der in der Halbleiterbranche üblichen Art und Weise verarbeitet werden. Die Herstellung von siliziumbasierten Interposern ist allerdings sehr teuer, sodass es zunehmend Bestrebungen gibt, diese durch kostengünstigeres Glasmaterial zu ersetzen, da Glas hinsichtlich seiner Temperaturausdehnung an Silizium angepasst werden kann.

Als Herausforderung gestaltet sich hier die Verarbeitung des Glases zu gebrauchsfähigen Interposern. Insbesondere die wirtschaftliche Einbringung der Vielzahl von Durchbrechungen in das Substrat zur Durchkontaktierung ist im Stand der Technik noch nicht gelöst.

So ist aus der EP 2 503 859 A1 ein Verfahren bekannt, bei dem ein Substrat mit Durchgangslöchern versehen wird, wobei das Substrat aus einem Isolator wie Glas, beispielsweise Silikatglas, Saphir, Kunststoff oder Keramik und Halbleitern wie Silizium besteht. Das Substrat wird mit einem Laser, beispielsweise einem Femtosekundenlaser, bestrahlt, der auf einen Fokuspunkt an einer gewünschten Position innerhalb des Substrates fokussiert wird. Die Durchgangslöcher werden mit einem Verfahren erzeugt, bei dem das Substrat mit den durch den Laser modifizierten Bereichen in eine Ätzlösung getaucht wird und so die modifizierten Bereiche aus dem Substrat entfernt werden. Dieses Ätzen nutzt den Effekt, dass im Vergleich zu Bereichen des Substrates, die nicht modifiziert wurden, der modifizierte Bereich extrem schnell geätzt wird. Auf diese Weise können Sackbohrungen oder Durchgangsöffnungen erzeugt werden. Für das Füllen der Durchgangsöffnung eignet sich eine Kupferlösung. Um eine gewünschte "Tiefenwirkung", also ein Durchgangsloch zwischen den Substrataußenseiten zu erreichen, muss der Fokuspunkt bei fortgesetzter Bestrahlung entsprechend verlagert, also in Richtung der Z-Achse nachgeführt werden.

Ganz allgemein ist die Kombination einer selektiven Laserbehandlung mit einem nachfolgenden Ätzprozess als selektives laserinduziertes Ätzen auch unter der Bezeichnung ISLE bekannt (In-volume selective laser-induced etching). Dieses Verfahren dient der Herstellung von Mikrobauteilen, Kanälen und geformten Ausschnitten in transparenten Materialien wie Gläsern oder Saphir. Die Miniaturisierung von Produkten für die Mikrooptik, Medizintechnik und Mikrosystemtechnik erfordert die Herstellung von Komponenten mit Abmessungen im Bereich von Mikrometern und mit Strukturgenauigkeiten von bis zu 100 nm. Das ISLE-Verfahren ist ein geeignetes Fertigungsverfahren für Strukturen aus und in transparenten Materialien. Durch die Fokussierung der Laserstrahlung im Inneren des Werkstückes wird das Material in einem kleinen Volumen (einige Kubikmikrometer) strukturell verändert. Beispielsweise wird die Kristallstruktur von Saphir in eine amorphe glasartige Struktur umgewandelt, welche 10.000-fach schneller geätzt wird als das Ausgangsmaterial. Durch Bewegen des Laserfokus durch das Werkstück werden zusammenhängende modifizierte Gebiete erzeugt, welche nachfolgend mittels Kaliumhydroxid oder Flusssäure in wässriger Lösung chemisch geätzt und entfernt werden. Aus der DE 10 2010 025 966 B4 ist ein Verfahren bekannt, bei dem in einem ersten Schritt auf das Substrat fokussierte Laserimpulse gerichtet werden, deren Strahlungsintensität so stark ist, dass es zu lokaler, athermischer Zerstörung entlang eines filamentartigen Kanales im Glas kommt. In einem zweiten Verfahrensschritt werden die filamentartigen Kanäle zu Löchern aufgeweitet, indem gegenüberstehenden Elektroden Hochspannungsenergie zugeführt wird, was zu dielektrischen Durchbrüchen durch das Substrat entlang der filamentartigen Kanäle führt. Diese Durchbrüche erweitern sich durch elektrothermische Aufheizung und Verdampfung von Lochmaterial, bis der Vorgang bei Erreichen des gewünschten Lochdurchmessers durch Abschalten der Energiezufuhr gestoppt wird. Alternativ oder zusätzlich können die Kanäle auch durch reaktive Gase aufgeweitet werden, die mittels Düsen auf die Lochungsstellen gerichtet werden. Die Durchbruchsstellen können auch durch zugeführtes Ätzgas aufgeweitet werden. Als nachteilig erweist sich der vergleichsweise aufwendige Vorgang, der dadurch entsteht, dass zuerst durch die athermische Zerstörung das Substrat durchbrochen und im nächsten Schritt der Durchmesser der filamentartigen Kanäle zu Löchern aufgeweitet werden muss.

Ferner ist aus der US 6,400,172 B1 das Einbringen von Durchbrechungen in Halbleitermaterialien mittels Laser bekannt.

Der Erfindung liegt die Aufgabe zugrunde, eine Möglichkeit zu schaffen, ein Verfahren zum Einbringen von Durchbrechungen wesentlich zu vereinfachen und insbesondere den Zeitaufwand für die Durchführung zu vermindern.

Die Aufgabe wird erfindungsgemäß mit einem Verfahren gemäß den Merkmalen des Anspruches 1 gelöst. Die weitere Ausgestaltung der Erfindung ist den Unteransprüchen zu entnehmen.

Erfindungsgemäß ist also ein Verfahren vorgesehen, bei dem die Laserstrahlung zunächst durch ein transmissives Medium, insbesondere ein Glas, hindurch gelenkt wird, wobei das Medium einen größeren intensitätsabhängigen Brechungsindex als Luft aufweist, und anschließend auf das Substrat trifft und die Laserstrahlung durch nichtlineare Selbstfokussierung innerhalb der Pulsdauer eines Einzelpulses durch das unveränderte, optische System mit einer von der ursprünglichen Brennweite abweichenden Brennweite fokussiert wird. Die Erfindung macht sich dabei zunutze, dass die Intensität eines gepulsten Lasers bezogen auf einen Einzelpuls nicht konstant ist, sondern über den zeitlichen Verlauf des Einzelpulses eine bis zu einem Maximum ansteigende und danach abfallende Intensität aufweist. Indem aufgrund der zunehmenden Intensität auch der Brechungsindex, bezogen auf einen Einzelpuls über den zeitlichen Verlauf entsprechend einer Normalverteilung, bis zu einem Maximum zunimmt, verändert sich die Brennweite des optischen Systems, also der Abstand von einem Laserbearbeitungskopf bzw. der Linse, und zwar unabhängig von der durch die Fokussieroptik bestimmten geometrischen Fokuslage. Dieser Effekt wird durch das transmissive Medium quasi derart verstärkt, dass der Abstand der Fokuslagen zwischen einer maximalen und einer minimalen Intensität zumindest der gewünschten Längserstreckung, also der Tiefe der einzubringenden Ausnehmung entspricht. Daraus ergibt sich in verblüffend einfacher Weise eine örtliche Verlagerung in Richtung der Strahlachse während der Dauer eines Einzelpulses, die zu der gewünschten Modifikation im Bereich der gesamten Haupterstreckung in Richtung der Strahlachse der später einzubringenden Ausnehmungen führt. Dabei kann auf eine Nachführung der Fokuslage, wie dies beim Stand der Technik unvermeidlich ist, verzichtet werden. Insbesondere ist also keine Steuerung für die Bewegung des Laserfokus durch das Substrat erforderlich. Damit entfällt erfindungsgemäß nicht nur der hierzu erforderliche Steuerungsaufwand, sondern auch die Bearbeitungsdauer wird erheblich, beispielsweise auf die Dauer eines Einzelpulses reduziert. Der nichtlineare Brechungsindex des transmissiven Mediums hängt dabei linear von der Intensität ab, sodass die Auswahl hinsichtlich eines geeigneten Materials sowie der geeigneten Abmessungen von der Intensität der eingesetzten Laserstrahlung abhängt.

Dabei wird der Laserstrahl derart kurzzeitig auf das Substrat gerichtet, dass lediglich eine Modifikation des Substrates entlang einer Strahlachse des Laserstrahles erfolgt, ohne dass es zu einer das Substrat durchdringenden Ausnehmung des Substrates kommt, wobei im nächsten Schritt ein anisotroper Materialabtrag nur in denjenigen Bereichen des Substrates durchgeführt wird, die zuvor eine Modifikation mittels des Laserstrahles erfahren haben, und so eine Ausnehmung oder Durchbrechung in das Substrat eingebracht wird. Obwohl der erfindungsgemäße Prozess noch nicht abschließend verstanden worden ist, wird derzeit davon ausgegangen, dass es aufgrund der Lasereinwirkung bei der Modifikation zu einer chemischen Umwandlung des Substratmaterials kommt, welche nur geringe Auswirkungen auf die physikalischen Eigenschaften bzw. die äußerliche Beschaffenheit des Substrates hat. Der Laserenergieeintrag dient dabei zur Anregung bzw. Auslösung einer Reaktion und einer Modifikation durch Umwandlung, deren Wirkung erst im nachfolgenden Verfahrensschritt zu dem gewünschten Materialabtrag genutzt wird.

Indem der anisotrope Materialabtrag durch ein Ätzverfahren, insbesondere durch Flüssigätzen, Trockenätzen oder Dampfphasenätzen, oder durch Verdampfen mittels Hochspannung oder Hochfrequenz erfolgt, ist für den eigentlichen Materialabtrag kein sequentielles, sondern ein flächig einwirkendes Abtragsverfahren nutzbar, welches lediglich sehr geringe Anforderungen an den Prozess stellt. Vielmehr lässt sich über die Einwirkungsdauer der Materialabtrag quantitativ und qualitativ für alle in der beschriebenen Weise vorbehandelten und dementsprechend modifizierten Bereiche zugleich durchführen, sodass der Zeitaufwand für die Erzeugung der Vielzahl der Ausnehmungen oder Durchbrechungen in der Summe wesentlich reduziert ist.

Der Fokuspunkt bei minimaler Intensität könnte auf eine äußere Oberfläche des Substrates gerichtet werden. Als besonders Erfolg versprechend hat es sich hingegen bereits erwiesen, wenn die Laserstrahlung auf eine abgewandte Seite des Substrates beabstandet zu diesem fokussiert wird, sodass der Fokuspunkt der Laserstrahlung so eingestellt wird, dass dieser auf einer der Laserstrahlung abgewandten Rückseite mit Abstand zu der Oberfläche des Substrates liegt. Hierdurch wird also zunächst der Laserstrahl auf einen außerhalb des Substrates liegenden Fokuspunkt gerichtet. Der aufgrund der zunehmenden Intensität veränderte Brechungsindex führt dann zu einer örtlichen Verlagerung des Fokuspunktes entlang der Strahlachse durch das Substrat hindurch. Dadurch wird sichergestellt, dass jeder Fokuspunkt innerhalb des Substrates mit einer zur Erzeugung der Modifikation ausreichend hohen Intensität beaufschlagt ist.

Selbstverständlich kann die Dauer der Strahleinwirkung bei unveränderter relativer Position des Laserbearbeitungskopfes gegenüber dem Substrat mehrere Pulslängen umfassen, um so beispielsweise die Modifikation des Substratmaterials weiter zu optimieren. Besonders vorteilhaft ist es hingegen, wenn die Laserstrahlung für die Dauer eines Einzelpulses auf einem jeweiligen Fokuspunkt gelenkt wird. Somit sind also vorhergehende ebenso wie nachfolgende Pulse des Laserstrahles auf in der Ebene des Substrates beabstandete Positionen gerichtet, sodass benachbarte Fokuspunkte einen Abstand in der Ebene des Substrates aufweisen.

Die Modifikationen könnten durch eine Laserbearbeitung eingebracht werden, bei der eine Positionierung des Laserbearbeitungskopfes und die Laserbearbeitung abwechselnd durchgeführt werden. Vorzugsweise wird hingegen, während die Laserstrahlung auf das Substrat gelenkt wird, eine stetige Relativbewegung zwischen dem Laserstrahl bzw. dem Laserbearbeitungskopf und dem Substrat durchgeführt, sodass also der Laserstrahl kontinuierlich in einer "fliegenden" Bewegung über das Substrat geführt wird, sodass also eine ununterbrochene Änderung der Relativposition eine extrem schnelle Bearbeitungsdauer des Substrates ergibt. Insbesondere kann die relative Position des Substrates in Bezug auf den Laserstrahl mit konstanter Geschwindigkeit verändert werden, sodass bei einer konstanten Pulsfrequenz der Abstand der zu erzeugenden Modifikationen einem vorbestimmten Rastermaß folgt.

Besonders bevorzugt wird der Laser mit einer Wellenlänge betrieben, für die das Substrat transparent ist, sodass eine Durchdringung des Substrates sichergestellt ist. Insbesondere wird dadurch eine im Wesentlichen zylindrische Modifikationszone koaxial zu der Laserstrahlachse herum sichergestellt, die zu einem konstanten Durchmesser der Durchbrechung oder der Ausnehmung führt.

Darüber hinaus kann es auch von Vorteil sein, wenn durch den Laser zusätzlich auch ein Oberflächenbereich abgetragen wird, um die Einwirkungszone des anisotropen Abtrages derart auszugestalten, dass ein kegelförmiger Einlassbereich der Durchbrechung entsteht. Auf diese Weise kann die spätere Durchkontaktierung vereinfacht werden. Zudem wird in diesem Bereich beispielsweise die Einwirkung eines Ätzmittels konzentriert.

Die Pulsdauer kann gegenüber den aus dem Stand der Technik bekannten Verfahren wesentlich reduziert werden. Bei einer besonders vorteilhaften Ausgestaltung des erfindungsgemäßen Verfahrens kann der Laser mit einer Pulsdauer von weniger als 50 ps, vorzugsweise weniger als 20 ps betrieben werden.

Bei einer anderen, ebenfalls besonders Erfolg versprechenden Ausgestaltung der Erfindung wird das Substrat insbesondere nach der Modifikation mit einer flächigen, zumindest einzelnen, insbesondere eine Vielzahl von nachfolgend einzubringenden Durchbrechungen abdeckenden Metallschicht versehen. In einem folgenden Schritt werden die modifizierten Bereiche so abgetragen, dass eine von der Metallschicht einseitig verschlossene Ausnehmung erzeugt wird. Dabei wird die Metallschicht vorzugsweise nach der Modifikation, jedoch vor dem Materialabtrag aufgebracht, sodass nach dem Materialabtrag die beispielsweise als Leiterbahn aufgebrachte Metallschicht die Ausnehmung verschließt und dadurch zugleich eine optimale Basis für eine daran anzubringende Kontaktierung bildet. Die Durchkontaktierung erfolgt dabei im Bereich der Ausnehmung mit an sich bekannten Verfahren. Indem die Metallschicht als Leiterbahn aufgebracht wird, kann zudem in einfacher Weise ein gewünschtes Schaltbild erzeugt werden.

Bei einer anderen, ebenfalls besonders Erfolg versprechenden Ausgestaltung des Verfahrens wird das Substrat vor der Laserbehandlung mit einem Ätzresist auf zumindest einer Oberfläche flächig beschichtet. Durch Einwirkung eines Laserstrahles wird zugleich in einer punktförmigen Einwirkungszone das Ätzresist auf zumindest einer Oberfläche abgetragen und die Modifikation in dem Substrat erzeugt. Auf diese Weise werden die nicht modifizierten Bereiche vor einer unerwünschten Einwirkung im nachfolgenden Ätzprozess geschützt und die Oberfläche daher nicht beeinträchtigt. Dabei behindert das Ätzresist nicht die Modifikation des darunter liegenden Substrates. Vielmehr ist das Ätzresist für die Laserstrahlung entweder durchlässig oder wird nahezu punktförmig durch die Laserstrahlung abgetragen, beispielsweise also verdampft. Weiterhin ist nicht ausgeschlossen, dass das Ätzresist solche Substanzen enthält, die für die Modifikation unterstützend wirken, beispielsweise also den Modifikationsvorgang beschleunigen.

Selbstverständlich kann vor dem Auftrag des Ätzresists auf eine der Außenflächen des Substrates die vorstehend beschriebene Metallschicht aufgebracht werden, um diese nach dem Entfernen des Ätzresists als Basis für die gewünschte Durchkontaktierung zu verwenden.

Das Ätzresist könnte nach dem Abschluss der Behandlung auf der Oberfläche des Substrates verbleiben. Vorzugsweise wird jedoch das Ätzresist in an sich bekannter Weise nach dem anisotropen Materialabtrag von der Oberfläche des Substrates entfernt. Grundsätzlich ist das Verfahren nicht auf bestimmte Materialzusammensetzungen des Substrates beschränkt. Besonders Erfolg versprechend ist es allerdings, wenn das Substrat als einen wesentlichen Materialanteil ein Aluminosilikat, insbesondere ein Boro-Aluminosilikat aufweist.

Die zweitgenannte Aufgabe wird mit einer Vorrichtung mit einem Laserbearbeitungskopf zur Ablenkung einer Laserstrahlung auf ein Substrat dadurch gelöst, dass die Vorrichtung mit einem insbesondere mit zumindest einer ebenen Fläche ausgestatteten oder beispielsweise als eine Planplatte ausgeführten transmissiven Medium mit einem größeren intensitätsabhängigen Brechungsindex bzw. mit einer größeren intensitätsabhängigen Brechzahl als Luft ausgestattet ist, welches zwischen dem Laserbearbeitungskopf und dem Substrat angeordnet ist, derart, dass die Laserstrahlung durch das transmissive Medium hindurch auf das Substrat ablenkbar ist. Hierdurch wird erfindungsgemäß der intensitätsabhängige Brechungsindex bzw. die intensitätsabhängige Brechzahl des transmissiven Mediums genutzt, um in Verbindung mit einem gepulsten Laser während der Dauer jedes Einzelpulses und der damit einhergehenden Schwankung der Intensität während des Einzelpulses eine axiale Veränderung der Fokuslage zu erzeugen. Somit ist also anders als beim Stand der Technik die Fokuslage zumindest während der Dauer eines Einzelpulses nicht unverändert, sondern die Fokuslage verlagert sich bezogen auf die Gesamtdauer des Einzelpulses entlang einer Linie auf der Strahlachse. Es ist leicht verständlich, welche wesentlichen Vorteile sich bei der vorliegenden Erfindung dadurch ergeben, dass sich die Fokuslage ohne eine Nachführung der Fokussieroptik des Laserbearbeitungskopfes verlagert. Insbesondere wird dadurch die Bearbeitungsdauer wesentlich verkürzt und auch der Steuerungsaufwand vermindert. Beispielsweise kann bei einem ebenen Substrat auf die Nachführung der Z-Achse verzichtet werden.

Dabei ist grundsätzlich auch eine Variante denkbar, bei der das transmissive Medium in Richtung des Strahlenganges vor einer Fokussieroptik des Laserbearbeitungskopfes an diesem angeordnet ist, sodass die Laserstrahlung zunächst durch das transmissive Medium und anschließend durch die Fokussieroptik hindurch auf das Substrat gerichtet wird.

Der Effekt der intensitätsabhängigen Lichtbrechung kann selbstverständlich an den jeweiligen Verwendungszweck beispielsweise dadurch angepasst werden, dass das transmissive Medium entsprechend angepasst oder ausgetauscht wird oder dass der Laserstrahl mehrere transmissive Medien oder dasselbe Medium mehrfach durchläuft.

Der Fokuspunkt könnte auf eine dem Laserbearbeitungskopf abgewandte Rückseite des Substrates gerichtet werden und das transmissive Medium so beschaffen sein, dass der intensitätsabhängige Fokuspunkt bei dem Intensitätsmaximum eine dem Laserbearbeitungskopf zugewandte Vorderseite erreicht. Besonders praxisgerecht ist es hingegen, wenn die Laserstrahlung auf einen Fokuspunkt beabstandet zu einer dem Laserbearbeitungskopf abgewandten Rückseite des Substrates ablenkbar ist, sodass die Rückseite des Substrates nicht bei einem Intensitätsminimum, sondern erst im Verlauf zunehmender Intensität erreicht wird. Somit wird eine für die zu erzielende Modifikation stets ausreichende Intensität der Laserstrahlung innerhalb des Substrates sichergestellt.

Zur Bearbeitung ist grundsätzlich jeder gepulste Laser geeignet, wobei sich bereits ein Laser mit einer Pulsdauer von weniger als 50 ps, vorzugsweise weniger als 20 ps als besonders zweckmäßig erwiesen hat.

Zudem ist es besonders sinnvoll, wenn der Laserbearbeitungskopf zur Fokussierung eine Fokussieroptik mit einer numerischen Apertur (NA) größer als 0,3, insbesondere größer als 0,4 aufweist.

Eine besonders vielversprechende Gestaltung der erfindungsgemäßen Vorrichtung wird auch dadurch erreicht, dass die Fokussieroptik eine Gradienten-Index-Linse aufweist. Durch den Einsatz einer solchen, auch als GRIN-Linse bekannten Linse führt der in radialer Richtung abnehmende Brechungsindex dazu, dass die anderenfalls vorhandene Abschwächung der Intensität im Randbereich der Linse weitgehend ausgeglichen wird.

Weiterhin erweist es sich als vorteilhaft, wenn das transmissive Medium aus Glas, insbesondere aus Quarzglas besteht, um so einen ausgeprägten intensitätsabhängigen Brechungsindex zu realisieren.

Dabei ist das transmissive Medium vorzugsweise mit dem Laserbearbeitungskopf verbunden und mit diesem gemeinsam beweglich angeordnet sowie an dem Laserbearbeitungskopf insbesondere austauschbar angeordnet. Hierzu eignet sich beispielsweise eine Schnellfixierung.

Vorzugsweise ist die Vorrichtung zusätzlich zu einem Pulslaser mit einem kontinuierlich emittierenden Laser ausgestattet, wobei das transmissive Medium transparent für die Wellenlänge des kontinuierlich emittierenden Lasers ist und der kontinuierlich emittierende Laser durch das Medium hindurch auf das Substrat bzw. unter Umgehung des transmissiven Mediums auf das Substrat gerichtet wird. Die Wellenlänge des Pulslasers und des kontinuierlich emittierenden Lasers können dabei unterschiedlich sein. Weiterhin können die Laserstrahlungen der verschiedenen Laserquellen von unterschiedlichen Seiten auf das Substrat gerichtet werden.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig. 1: ein Ablaufdiagramm mit mehreren Verfahrensschritten zum Einbringen einer Mehrzahl von Durchbrechungen in ein Substrat durch anisotropen Materialabtrag;
- Fig. 2: eine Verfahrensvariante, bei der vor dem anisotropen Materialabtrag eine Metallschicht aufgebracht wird;
- Fig. 3: eine weitere Verfahrensvariante, bei der in einem ersten Verfahrensschritt ein Ätzresist auf das Substrat aufgebracht wird;
- Fig. 4: die intensitätsabhängige Fokuslage während eines Einzelpulses;
- Fig. 5: eine Diagrammdarstellung der Intensitätsverteilung über die Zeit während der Dauer eines Einzelpulses.

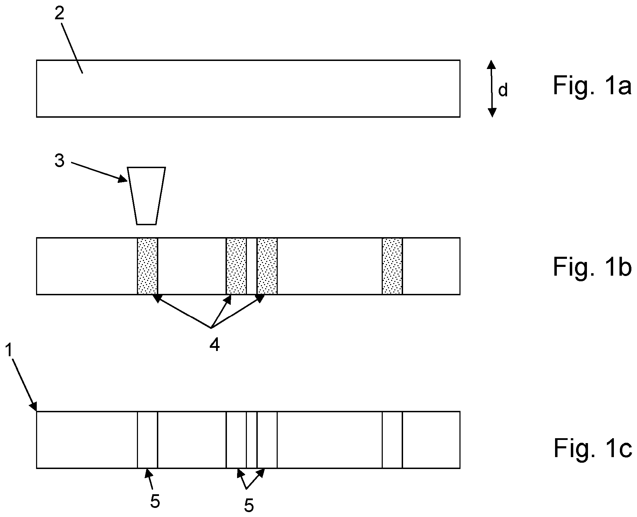

Figur 1 zeigt die einzelnen Verfahrensschritte beim Einbringen einer Mehrzahl von Durchbrechungen in einen als Kontaktierungselement in der Leiterplattenfertigung bestimmten Interposer 1 mit einem Substrat 2. Hierzu wird eine Laserstrahlung 3 auf die Oberfläche des Substrates 2 gerichtet. Das Substrat 2 weist als einen wesentlichen Materialanteil ein Boro-Aluminosilikat auf, um so eine Temperaturausdehnung ähnlich der von Silizium sicherzustellen. Die Materialstärke d des Substrates 2 beträgt dabei zwischen 50 µm und 500 µm. Die Einwirkungsdauer der Laserstrahlung 3 wird dabei äußerst kurz gewählt, sodass lediglich eine Modifikation des Substrates 2 konzentrisch um eine Strahlachse des Laserstrahles eintritt, ohne dass es zu einer wesentlichen durchgehenden Zerstörung bzw. einer Ausnehmung des Substratmaterials kommt. Insbesondere wird die Einwirkungsdauer auf einen Einzelpuls beschränkt. Hierzu wird der Laser mit einer Wellenlänge betrieben, für die das Substrat 2 transparent ist. Ein derart modifizierter Bereich 4 ist in Figur 1b dargestellt. In einem nachfolgenden, in Figur 1c dargestellten Verfahrensschritt kommt es aufgrund der Einwirkung einer nicht dargestellten ätzenden Flüssigkeit oder eines ätzendes Gases zu einem anisotropen Materialabtrag in denjenigen Bereichen 4 des Substrates 2, die zuvor eine Modifikation durch die Laserstrahlung 3 erfahren haben. Entlang der zylindrischen Einwirkungszone entsteht dadurch eine Ausnehmung 5 als Durchbrechung in dem Substrat 2.

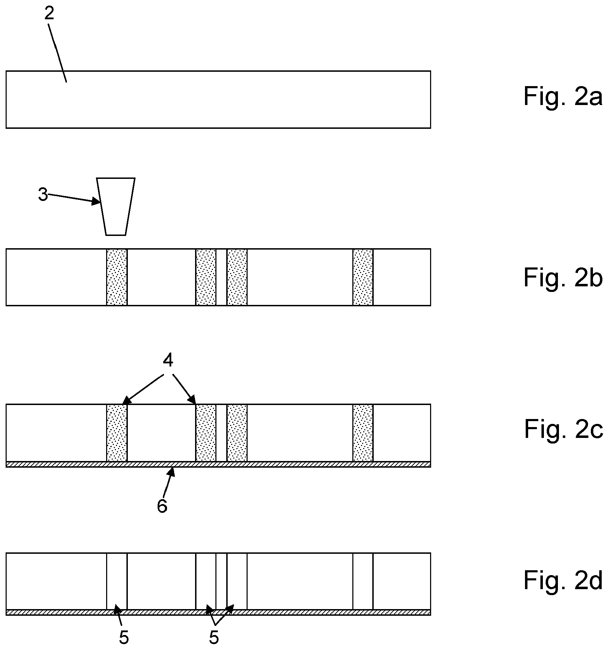

In Figur 2 wird eine Abwandlung desselben Verfahrens beschrieben, bei der das Substrat 2 nach der in Figur 2b gezeigten Modifikation durch die Laserstrahlung 3 mit einer flächigen Metallschicht 6 versehen wird, wie dies in Figur 2c zu erkennen ist. Durch den anisotropen Materialabtrag in den modifizierten Bereichen 4 entstehen im nächsten, in Figur 2d dargestellten Verfahrensschritt einseitig von der Metallschicht 6 verschlossene Ausnehmungen 5, welche die Basis für eine spätere Kontaktierung bilden.

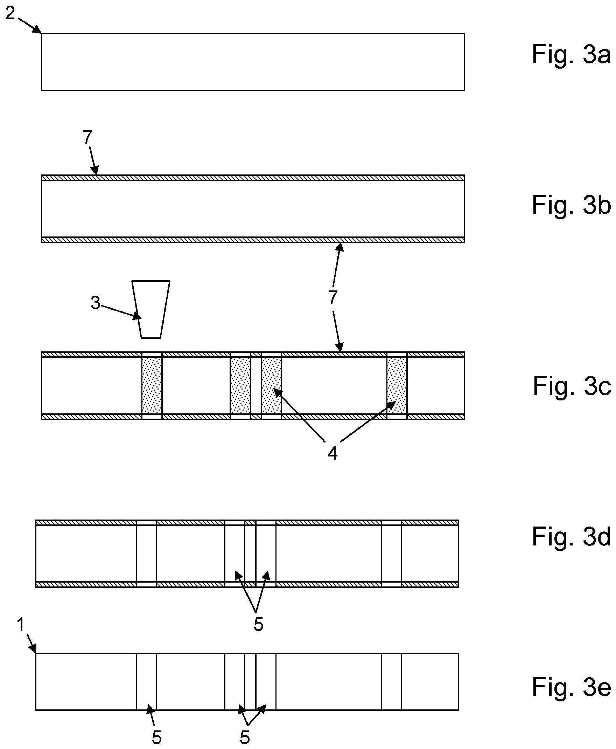

Eine weitere Variante des Verfahrens ist in Figur 3 dargestellt. Dabei wird das Substrat 2 vor der Laserbehandlung mittels der Laserstrahlung 3 beidseitig mit einem in Figur 3b dargestellten Ätzresist 7 beschichtet. Aufgrund der Einwirkung der Laserstrahlung 3 kommt es in einer punktförmigen Einwirkungszone zugleich zu einem Abtrag des Ätzresists 7 und zu einer Modifikation des darunter liegenden Bereiches des Substrates 2, wie dies in Figur 3c zu erkennen ist. Die nicht modifizierten Bereiche der Oberfläche des Substrates 2 sind so vor einer unerwünschten Einwirkung im nachfolgenden Ätzprozess geschützt, durch den, wie in Figur 3d dargestellt, der anisotrope Materialabtrag durch ein Flüssigätzverfahren erfolgt und entsprechende Ausnehmungen 5 in dem Substrat 2 entstehen. Durch ein sogenanntes Stripping-Verfahren wird, wie in Figur 3e gezeigt, das nach Abschluss des Ätzverfahrens entbehrliche Ätzresist 7 abgetragen.

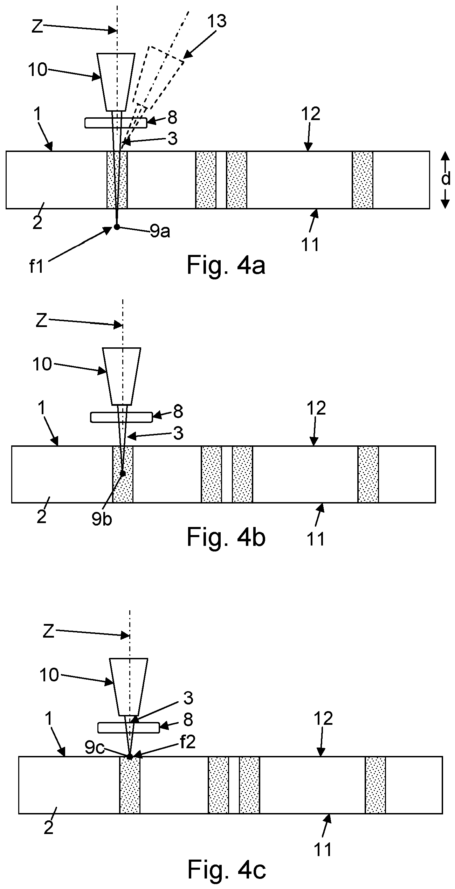

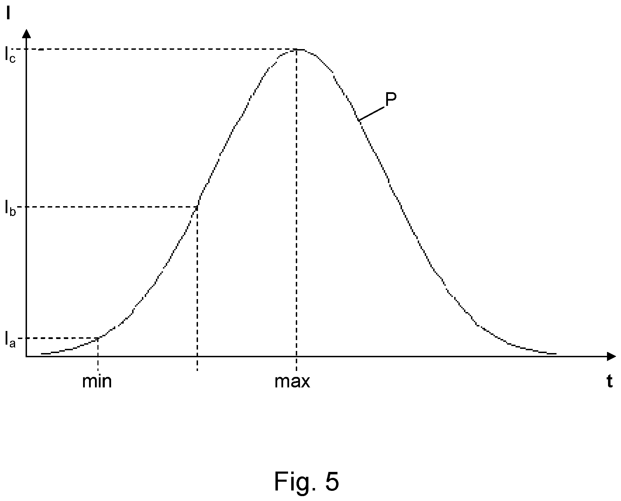

Anhand der Figuren 4 und 5 wird nachstehend ein wesentlicher Effekt während der Laserbearbeitung des Substrates 2 näher dargestellt. Dabei handelt es sich um die die intensitätsabhängige Fokuslage während eines Einzelpulses P. Die Erfindung geht dabei von der Erkenntnis aus, dass die Intensität I eines Einzelpulses P der Laserstrahlung 3 nicht konstant ist, sondern wie in Figur 5 dargestellt über den zeitlichen Verlauf des Einzelpulses eine von einem Minimum Iₐ über einen Mittelwert I_{b} bis zu einem Maximum I_{c} ansteigende und danach abfallende Intensität beispielsweise entsprechend einer Normalverteilung aufweist. Zugleich ändert sich aufgrund der veränderlichen Intensität I der Brechungsindex, insbesondere auch eines transmissiven Mediums 8, bezogen auf einen Einzelpuls P über den zeitlichen Verlauf t. Dadurch verändern sich auch die in den Figuren 4a bis 4c dargestellten intensitätsabhängigen Fokuslagen 9a, 9b, 9c der Laserstrahlung 3 unabhängig von der durch eine Fokussieroptik eines Laserbearbeitungskopfes 10 bestimmten geometrischen Fokuslage. Dieser Effekt wird durch das zwischen dem Laserbearbeitungskopf 10 und dem Substrat 2 angeordnete transmissive Medium 8 beispielsweise aus Glas, das einen größeren intensitätsabhängigen Brechungsindex als Luft aufweist, so verstärkt, dass der Abstand der Fokuslagen 9a, 9c zwischen einer maximalen Intensität I_{c} und einer minimalen Intensität Iₐ zumindest der gewünschten Längserstreckung, also der Tiefe der einzubringenden Ausnehmung bzw. wie dargestellt im Falle eines einzubringenden Durchgangsloches der Materialstärke d des Substrates 2 entspricht. Der intensitätsabhängige Fokuspunkt 9a, 9b, 9c wandert also entlang der Strahlachse Z ausgehend von einem zu einer Rückseite 11 des Substrates 2 beabstandeten, in der Figur 4a gezeigten Position in Richtung des Laserbearbeitungskopfes 10 und erreicht so in einer stetigen Bewegung alle Positionen entlang der Strahlachse Z zwischen der Rückseite 11 und einer dem Laserbearbeitungskopf 10 zugewandten Vorderseite 12, sodass es zu der gewünschten Modifikation im Bereich der gesamten Haupterstreckung der später einzubringenden Ausnehmungen kommt.

Ergänzend ist in Figur 4a lediglich andeutungsweise ein zusätzlicher Laserbearbeitungskopf 13 dargestellt, durch den die Laserstrahlung 3 eines gepulsten Lasers ergänzend zu einer mit dem Laserbearbeitungskopf 10 verbundenen kontinuierlich emittierenden Laserquelle wahlweise durch das transmissive Medium 8 hindurch oder unter Umgehung desselben auf das Substrat 2 gerichtet wird. Hierdurch wird die in Figur 5 dargestellte Intensität I eines Einzelpulses P der Laserstrahlung 3 entsprechend durch die Intensität der kontinuierlich emittierenden Laserquelle verstärkt.

## Patentansprüche

1. Verfahren zum Einbringen einer Mehrzahl von Ausnehmungen (5) in ein insbesondere ebenes Substrat (2) mittels eines optischen Systems, wobei die Dicke des Substrates (2) im Bereich der einzubringenden Ausnehmungen (5) 2 mm nicht übersteigt, mittels gepulster Laserstrahlung (3) mit einer Pulsdauer (t), wobei das Substratmaterial des Substrates (2) für die Laserwellenlänge zumindest teilweise transparent ist und die Laserstrahlung (3) mit Hilfe des optischen Systems der Brennweite (f1) fokussiert wird und die Intensität der Laserstrahlung (3) zu einer Modifikation des Substrates (2) entlang einer Strahlachse (Z) der Laserstrahlung (3), jedoch nicht zu einem durchgehenden Materialabtrag führt, wobei die Laserstrahlung (3) durch nichtlineare Selbstfokussierung innerhalb der Pulsdauer (t) eines Einzelpulses (P) durch dasselbe, an sich unveränderte, optische System mit einer von der ursprünglichen Brennweite (f1) verschiedenen Brennweite (f2) fokussiert wird, **dadurch gekennzeichnet, dass** die Laserstrahlung (3) zunächst durch ein transmissives Medium (8) hindurch gelenkt wird, wobei das transmissive Medium (8) einen größeren intensitätsabhängigen Brechungsindex als Luft aufweist und
1. die Intensität (I) eines Einzelpulses (P) der Laserstrahlung (3) über den zeitlichen Verlauf des Einzelpulses eine von einem Minimum (Iₐ) über einen Mittelwert bis zu einem Maximum (I_{c}) ansteigende und danach abfallende Intensität aufweist,
2. und sich dadurch die Brennweite des optischen Systems unabhängig von der durch die Fokussieroptik bestimmten geometrischen Fokuslage verändert, und dieser Effekt durch das transmissive Medium (8) derart verstärkt wird, dass der Abstand der Fokuslagen zwischen einer maximalen und einer minimalen Intensität (I) zumindest der gewünschten Längserstreckung der einzubringenden Ausnehmung (5) entspricht,
3. wodurch sich unabhängig von der durch die Fokussieroptik des Laserbearbeitungskopfes (10) bestimmten geometrischen Fokuslage die intensitätsabhängigen Fokuslagen der Laserstrahlung (3) verändern, sodass im nächsten Schritt ein anisotroper Materialabtrag hauptsächlich in denjenigen Bereichen erfolgt, die zuvor eine Modifikation mittels der Laserstrahlung (3) erfahren haben, und so eine Ausnehmung (5) in das Substrat (2) eingebracht wird.

2. Verfahren nach Anspruch 1, **dadurch gekennzeichnet, dass** der Abstand der Fokuslage zwischen einer maximalen und einer minimalen Intensität (I) größer ist als die Dicke des Substrates (2) im Bereich der einzubringenden Ausnehmung (5).

3. Verfahren nach zumindest einem der vorhergehenden Ansprüche, **dadurch gekennzeichnet, dass** das Substrat (2) als einen wesentlichen Materialanteil Glas, Saphir und/oder Silizium aufweist.

4. Verfahren nach zumindest einem der vorhergehenden Ansprüche, **dadurch gekennzeichnet, dass** der anisotrope Materialabtrag durch Ätzung in Fluorwasserstoffsäure durchgeführt wird.

5. Verfahren nach zumindest einem der vorhergehenden Ansprüche, **dadurch gekennzeichnet, dass** das Substrat (2) vor der Laserbestrahlung zumindest einseitig mit einem Ätzresist (7) beschichtet wird.

6. Verfahren nach Anspruch 5, **dadurch gekennzeichnet, dass** das Substrat (2) vor der Laserbehandlung mit einem Ätzresist (7) auf zumindest einer Oberfläche flächig beschichtet wird und dass durch Einwirkung der Laserstrahlung (3) zugleich in einer punktförmigen Einwirkungszone das Ätzresist (7) abgetragen und auf zumindest einer Oberfläche die Modifikation in dem Substrat (2) erzeugt wird.

7. Verfahren nach Anspruch 5 oder 6, **dadurch gekennzeichnet, dass** das Ätzresist (7) nach dem anisotropen Materialabtrag von der Oberfläche des Substrates (2) entfernt wird.

8. Verfahren nach zumindest einem der vorhergehenden Ansprüche, **dadurch gekennzeichnet, dass** das Substrat (2) zumindest einseitig mit einem Metall beschichtet wird.

9. Verfahren nach Anspruch 8, **dadurch gekennzeichnet, dass** das Substrat (2) insbesondere nach der Modifikation mit einer flächigen, zumindest einzelne, insbesondere eine Vielzahl von nachfolgend einzubringenden Ausnehmungen (5) und/oder Durchbrechungen abdeckenden Metallschicht (6) versehen wird und dass in einem folgenden Schritt die modifizierten Bereiche (4) abgetragen werden, sodass von der Metallschicht (6) einseitig verschlossene Ausnehmungen (5) erzeugt werden.

10. Verfahren nach zumindest einem der vorhergehenden Ansprüche, **dadurch gekennzeichnet, dass** die numerische Apertur (NA) des optischen Systems größer ist als 0,3, insbesondere größer als 0,4.

11. Verfahren nach zumindest einem der vorhergehenden Ansprüche, **dadurch gekennzeichnet, dass** die Laserstrahlung (3) für die Pulsdauer (t) eines Einzelpulses (P) auf einen jeweiligen Fokuspunkt (9a, 9b, 9c) gelenkt wird und der jeweilige Fokuspunkt (9a, 9b, 9c) während der Pulsdauer (t) eines Einzelpulses um zumindest 30 µm, insbesondere zumindest 50 µm in Richtung der Strahlachse (Z) der Laserstrahlung (3) verlagert wird.

12. Verfahren nach zumindest einem der vorhergehenden Ansprüche, **dadurch gekennzeichnet, dass** während die Laserstrahlung (3) auf das Substrat (2) einwirkt, das Substrat (2) relativ zu der Laserstrahlung (3) und/oder dem Laserbearbeitungskopf (10) insbesondere unterbrechungsfrei bewegt wird.

13. Verfahren nach zumindest einem der vorhergehenden Ansprüche, **dadurch gekennzeichnet, dass** durch die Laserstrahlung (3) zusätzlich auch ein Oberflächenbereich abgetragen wird.

14. Verfahren nach zumindest einem der vorhergehenden Ansprüche, **dadurch gekennzeichnet, dass** die Laserstrahlung (3) eines gepulsten Lasers durch das transmissive Medium (8) und die Laserstrahlung eines insbesondere kontinuierlich emittierenden Lasers durch das transmissive Medium (8) oder unter Umgehung des transmissiven Mediums (8) auf das Substrat (2) gerichtet wird.

## Claims

1. Method for introducing a plurality of cutouts (5) into a substrate (2), in particular a planar substrate (2), by means of an optical system, wherein the thickness of the substrate (2) in the region of the cutouts (5) to be introduced does not exceed 2 mm, by means of pulsed laser radiation (3) with a pulse duration (t), wherein the substrate material of the substrate (2) is at least partially transparent to the laser wavelength and the laser radiation (3) is focused by means of the optical system of the focal depth (f1) and the intensity of the laser radiation (3) leads to a modification of the substrate (2) along a beam axis (Z) of the laser radiation (3), but not to a removal of material right through, wherein the laser radiation (3) is focused by non-linear self-focusing within the pulse duration (t) of a single pulse (P) by the same, itself unchanged, optical system with a focal depth (f2) different from the original focal depth (f1), **characterized in that** the laser radiation (3) is first directed through a transmissive medium (8), wherein the transmissive medium (8) has a greater intensity-dependent refraction index than air and
1. the intensity (I) of a single pulse (P) of the laser radiation (3) over the time of the single pulse has an intensity that increases from a minimum (Iₐ) through a mean value to a maximum (I_{c}) and then falls,
2. and as a result, the focal depth of the optical system changes irrespective of the geometrical focal position determined by the focusing optic, and this effect is enhanced by the transmissive medium (8) in such a way that the distance of the focal positions between a maximum and a minimum intensity (I) corresponds at least to the desired longitudinal extent of the cutout (5) to be introduced,
3. whereby, irrespective of the geometrical focal position determined by the focusing optic of the laser processing head (10), the intensity-dependent focal positions of the laser radiation (3) change, so that in the next step an anisotropic material removal takes place mainly in those regions that have previously undergone a modification by means of the laser radiation (3), and so a cutout (5) is introduced into the substrate (2).

2. Method according to Claim 1, **characterized in that** the distance of the focal position between a maximum and a minimum intensity (I) is greater than the thickness of the substrate (2) in the region of the cutout (5) to be introduced.

3. Method according to at least one of the preceding claims, **characterized in that** the substrate (2) comprises glass, sapphire and/or silicon is a significant proportion of the material.

4. Method according to at least one of the preceding claims, **characterized in that** the anisotropic material removal is carried out by etching in hydrofluoric acid.

5. Method according to at least one of the preceding claims, **characterized in that** a substrate (2) is coated at least on one side with an etching resist (7) before the laser irradiation.

6. Method according to Claim 5, **characterized in that** the substrate (2) is coated with an etching resist (7) over the area of at least one surface and **in that**, by exposure to the laser radiation (3), the etching resist (7) is removed and on at least one surface the modification is created in the substrate (2) at the same time in an exposure zone in point form.

7. Method according to Claim 5 or 6, **characterized in that** the etching resist (7) is removed from the surface of the substrate (2) after the anisotropic material removal.

8. Method according to at least one of the preceding claims, **characterized in that** the substrate (2) is coated at least on one side with a metal.

9. Method according to Claim 8, **characterized in that** the substrate (2) is provided, in particular after the modification, with a metal layer (6) over the surface area, covering at least individual, in particular multiple, cutouts (5) and/or through-openings to be subsequently introduced, and **in that**, in a following step, the modified regions (4) are removed, so that cutouts (5) enclosed on one side by the metal layer (6) are created.

10. Method according to at least one of the preceding claims, **characterized in that** the numerical aperture (NA) of the optical system is greater than 0.3, in particular greater than 0.4.

11. Method according to at least one of the preceding claims, **characterized in that**, for the pulse duration (t) of a single pulse (P), the laser radiation (3) is directed onto a respective focal point (9a, 9b, 9c) and, during the pulse duration (t) of a single pulse, the respective focal point (9a, 9b, 9c) is shifted by at least 30 µm, in particular at least 50 µm, in the direction of the beam axis (Z) of the laser radiation (3).

12. Method according to at least one of the preceding claims, **characterized in that**, while the laser radiation (3) is acting on the substrate (2), the substrate (2) is moved, in particular uninterruptedly, in relation to the laser radiation (3) and/or the laser processing head (10) .

13. Method according to at least one of the preceding claims, **characterized in that** a surface region is additionally also removed by the laser radiation (3).

14. Method according to at least one of the preceding claims, **characterized in that** the laser radiation (3) of a pulsed laser is directed onto the substrate (2) through the transmissive medium (8) and the laser radiation of a laser, in particular a continuously emitting laser, is directed onto the substrate (2) through the transmissive medium (8) or while bypassing the transmissive medium (8) .

## Revendications

1. Procédé de réalisation d'une pluralité d'évidements (5) dans un substrat (2), notamment plan, au moyen d'un système optique, l'épaisseur du substrat (2) au niveau des évidements (5) à réaliser au moyen d'un rayonnement laser puisé (3) d'une durée d'impulsion (t) n'excédant pas 2 mm, le matériau du substrat (2) étant au moins partiellement transparent pour la longueur d'onde laser et le rayonnement laser (3) étant focalisé à l'aide du système optique à la focale (f1) et l'intensité du rayonnement laser (3) conduisant à une modification du substrat (2) le long d'un axe de faisceau (Z) du rayonnement laser (3), mais ne conduisant pas à une ablation de matériau continue, le rayonnement laser (3) étant focalisé par autofocalisation non linéaire pendant la durée d'impulsion (t) d'une seule impulsion (P) par le même système optique, non modifié en soi, ayant une focale (f2) différente de la focale (f1) d'origine, **caractérisé en ce que** le rayonnement laser (3) est d'abord dirigé à travers un milieu transmissif (8), le milieu transmissif (8) ayant un indice de réfraction dépendant de l'intensité qui est supérieur à celui de l'air et
1. l'intensité (I) d'une impulsion individuelle (P) du rayonnement laser (3) comportant au cours de la variation temporelle de l'impulsion individuelle une intensité croissant d'un minimum (Iₐ) à un maximum (I_{c}), en passant par une valeur moyenne, puis décroissant,
2. et ainsi la focale du système optique variant indépendamment de la position de focalisation géométrique déterminée par l'optique de focalisation, et cet effet étant renforcé par le milieu transmissif (8) de telle manière que la distance entre les positions de focalisation entre une intensité maximale et une intensité minimale (I) corresponde au moins à l'extension longitudinale souhaitée de l'évidement (5) à réaliser,
3. en conséquence, indépendamment de la position de focalisation géométrique déterminée par l'optique de focalisation de la tête de traitement laser (10), les positions de focalisation, dépendant de l'intensité, du rayonnement laser (3) variant de manière à effectuer à l'étape suivante une ablation de matériau anisotrope, principalement dans les zones qui ont subi préalablement une modification au moyen du rayonnement laser (3), et à réaliser ainsi un évidement (5) dans le substrat (2).

2. Procédé selon la revendication 1, **caractérisé en ce que** la distance de la position de focalisation entre une intensité maximale et une intensité minimale (I) est supérieure à l'épaisseur du substrat (2) au niveau de l'évidement (5) à réaliser.

3. Procédé selon l'une au moins des revendications précédentes, **caractérisé en ce que** le substrat (2) comporte du verre, du saphir et/ou du silicium dans une proportion de matériau importante.

4. Procédé selon l'une au moins des revendications précédentes, **caractérisé en ce que** l'ablation de matériau anisotrope est réalisée par gravure dans de l'acide fluorhydrique.

5. Procédé selon l'une au moins des revendications précédentes, **caractérisé en ce que** le substrat (2) est revêtu d'un vernis de gravure (7) sur au moins un côté avant le rayonnement laser.

6. Procédé selon la revendication 5, **caractérisé en ce que** le substrat (2) est revêtu de manière sensiblement bidimensionnelle d'un vernis de gravure (7) sur au moins une surface avant le traitement laser et **en ce que** le vernis de gravure (7) est éliminé simultanément par action du rayonnement laser (3) dans une zone d'action ponctuelle et la modification est réalisée dans le substrat (2) sur au moins une surface.

7. Procédé selon la revendication 5 ou 6, **caractérisé en ce que** le vernis de gravure (7) est éliminé de la surface du substrat (2) après l'ablation de matériau anisotrope.

8. Procédé selon l'une au moins des revendications précédentes, **caractérisé en ce que** le substrat (2) est revêtu d'un métal sur au moins un côté.

9. Procédé selon la revendication 8, **caractérisé en ce que** le substrat (2) est pourvu, notamment après la modification, d'une couche de métal (6) sensiblement bidimensionnelle, au moins individuelle, qui recouvre notamment un grand nombre d'évidements (5) et/ou de perforations à réaliser ultérieurement et **en ce que**, à une étape ultérieure, les zones modifiées (4) sont supprimées de façon à générer des évidements (5) fermés d'un côté par la couche de métal (6).

10. Procédé selon l'une au moins des revendications précédentes, **caractérisé en ce que** l'ouverture numérique (NA) du système optique est supérieure à 0,3, notamment supérieure à 0,4.

11. Procédé selon l'une au moins des revendications précédentes, **caractérisé en ce que** le rayonnement laser (3) est dirigé vers un point de focalisation respectif (9a, 9b, 9c) pendant la durée d'impulsion (t) d'une impulsion individuelle (P) et le point de focalisation respectif (9a, 9b, 9c) est déplacé d'au moins 30 µm, en particulier d'au moins 50 µm, en direction de l'axe de faisceau (Z) du rayonnement laser (3) pendant la durée d'impulsion (t) d'une impulsion individuelle.

12. Procédé selon l'une au moins des revendications précédentes, **caractérisé en ce que**, tandis que le rayonnement laser (3) agit sur le substrat (2), le substrat (2) est déplacé notamment sans interruption par rapport au rayonnement laser (3) et/ou à la tête de traitement laser (10).

13. Procédé selon l'une au moins des revendications précédentes, **caractérisé en ce qu'**une zone de surface est également supprimée par le rayonnement laser (3).

14. Procédé selon l'une au moins des revendications précédentes, **caractérisé en ce que** le rayonnement laser (3) d'un laser puisé à travers le milieu transmissif (8), et le rayonnement laser d'un laser notamment à émission continue à travers le milieu transmissif (8) ou en contournant le milieu transmissif (8), sont dirigés sur le substrat (2).
